**Europäisches Patentamt**

**European Patent Office**

**Office européen des brevets**

(11) Publication number: **0 145 194**
**B1**

(12) **EUROPEAN PATENT SPECIFICATION**

(45) Date of publication of patent specification: **17.02.88**

(21) Application number: **84307280.2**

(22) Date of filing: **23.10.84**

(51) Int. Cl.⁴: **G 01 R 31/28**

(54) Automatic test equipment.

(30) Priority: **04.11.83 GB 8329485**

(43) Date of publication of application:
**19.06.85 Bulletin 85/25**

(45) Publication of the grant of the patent:
**17.02.88 Bulletin 88/07**

(84) Designated Contracting States:
**DE FR NL**

(56) References cited:
**GB-A-1 451 295**

**PROCEEDINGS OF THE NATIONAL
ELECTRONICS CONFERENCEvol. 36, 1982, Oak
Brook, Illinois, USA; S. IM AL-HARIRI et al. "An
easily testable structure for LSI and VLSI
circuits", pages 346-350**

**JOURNAL OF DIGITAL SYSTEMS vol. 5, no. 4,
1981, R ockville, Maryland, USA; J. GRASON et
al. "Digital test generation and des ign for
testability", pages 319-359**

(73) Proprietor: **Membrain Ltd
Ferndown Industrial Estate
Wimborne Dorset BH21 7PE (GB)**

(72) Inventor: **Lelievre, David Howard
45 Lynwood Drive
Merley Wimborne Dorset (GB)**
Inventor: **Brazier, Kevin Edward
49 Mountbatten Drive
Ferndown Wimborne Dorset (GB)**

(74) Representative: **Holt, Michael et al
Schlumberger Electronics (UK) Limited 124
Victoria Road
Farnborough Hampshire GU14 7PW (GB)**

Courier Press, Leamington Spa, England.

## Description

This invention relates to automatic test equipment, and particularly to in-circuit automatic test equipment.

In-circuit automatic test equipment is used for testing the integrity of individual electronic components after they have been assembled on a printed circuit board. To this end, a test fixture known as a bed-of-nails, comprising typically several hundred spring-loaded pins or nails, is placed against the circuit board (unit under test or UUT) so that each nail contacts a predetermined circuit junction or node on the UUT. Each component in turn is subjected to a programme of test signals appropriate to that component, applied by stimulus circuits via the nails contacting the nodes connected to the input terminals of the component. The resulting output signals are monitored by sensing circuits, via other nails contacting the output terminals of the component, to check whether the component is correctly inserted and operating in accordance with its specification. To isolate the component electrically and avoid perturbations caused by the operation of other interconnected components in the UUT, so-called guard signals are applied to selected nodes elsewhere in the circuit to suppress signal changes that would otherwise affect the component being tested.

To economise, there are usually fewer stimulus and sensing circuits than there are nails, with each stimulus or sensing circuit being multiplexed among a group of several (for example eight) nails.

Conventionally, the guard signals are applied by the same stimulus circuits as supply the test signals. Thus, in any one group of nails, only a nail selected by the multiplexing circuitry for connection to the stimulus circuit is active at any one time, to supply either a test signal or a guard signal.

This is inefficient and can cause particular problems if, in designing a test fixture, a need for an additional guard signal, is belatedly found when all multiplexed stimulus circuits having nails near the relevant node are already committed to other nodes; this necessitates an expensive modification to the test fixture.

According to this invention there is provided an in-circuit automatic test equipment for testing a digital integrated circuit, the integrated circuit being a component part of a unit under test and having a plurality of nails for contacting circuit nodes in the unit under test, the nails being arranged in groups;

a plurality of circuits, one circuit associated with each group, each for applying a test signal to the unit or sensing a signal in the unit,

means for selecting any one nail within each group to selectively connect each circuit to a node of the unit under test via a so selected nail;

means for controlling the circuits to apply and sense a pattern for the test signals sufficient to test the integrated circuit to the unit under test via the selected nails; characterised in that the equipment includes means for selectivity applying a guard signal to the unit via any one or more of the nails, other than the selected nails.

With this arrangement, any nail not committed to supplying an actual stimulus signal or to sensing an output signal can be used to supply guard signals, thereby increasing the flexibility of design of the test fixture.

An in-circuit automatic test equipment in accordance with this invention will now be described, by way of example, with reference to the accompanying drawings, in which:—

Figure 1 is a simplified block schematic diagram of an automatic test equipment; and

Figure 2 is a block diagram of a channel control array forming part of an automatic test equiment according to this invention.

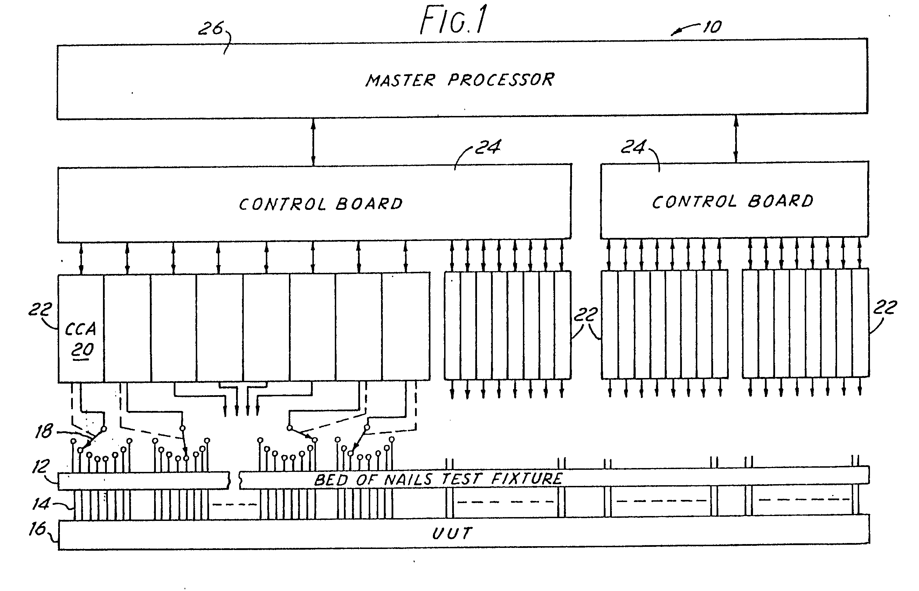

Referring to Figure 1, an in-circuit automatic test equipment (ATE) 10 includes a bed-of-nails test fixture 12 having a large number (for example 1024) of spring-loaded nails 14 arranged to contact selected circuit junctions or nodes in an electrical circuit 16 (the unit under test or UUT) when the fixture 12 is urged towards the UUT 16 by means not shown.

The nails 14 are arranged in groups of eight, and any one nail in a group can be selected by an eight-way switch or relay network 18 for connection to a respective channel control array (CCA) 20 in a module 22 containing eight such arrays. The channel control arrays 20 can generate and supply test signals to the selected nail 14, for application to the UUT 16, or receive the monitor output signals from the UUT via the selected nail. The operation of a pair of CCA modules 22 is controlled by a common control board 24, which is in turn operated by a master processor 26.

For clarity, only some of the nail groups and switches 18 for one only of the CCA modules 22 have been shown in Figure 1. A typical ATE might have 8 sets of control boards 24 and pairs of modules 22, giving a total of 128 CCA's 20 and 1024 nails.

The general principles of construction and operation of an in-circuit ATE 10 are well known in the art and form no part of this invention, and thus need not be described in detail here.

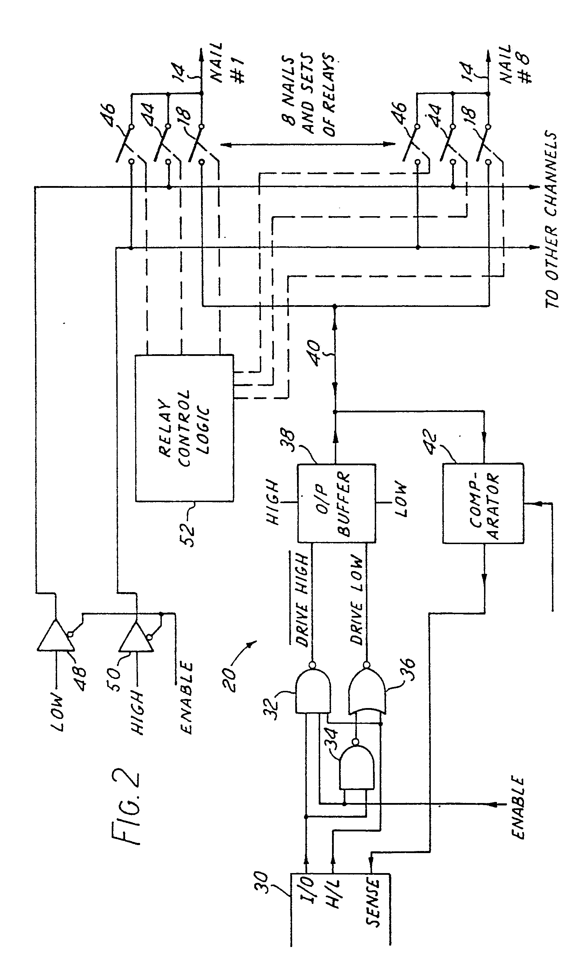

The deign and operation of one CCA will be described, with particular emphasis on the output buffer circuitry, with reference to Figure 2.

Referring to Figure 2, the CCA 20 generates I/O and H/L signals, as represented by block 30, indicating whether the channel is currently operating as an input or output channel, and, in the latter case, whether it is to supply a high or low signal for the current step of the test programme. These signals are combined with an enable signal by NAND-gates 32 and 34 and a NOR-gate 36 to control a high-current output buffer 38, to generate high or low forcing signals on a line 40 for application to the UUT, or to adopt a high-impedance state to permit sensing of signals from the UUT.

Such signals from the UUT are supplied by the line 40 to a comparator 42 which supplies an output signal on a sense line to the block 30 in accordance with the value of the sensed signal relative to a reference signal REF. This output signal is analyzed by the CCA 20 and the control board 24 in the process of verifying the integrity of the component currently under test.

The line 40 is coupled to the nail 14 appropriate to each step of the test programme by energising the corresponding one of eight relays 18 (only two of which are shown in Figure 2 for the sake of clarity). The test programme is so arranged that at any given time one and only one relay 18 associated with a CCA 20 is closed.

Each nail 14 also has two further relays 44 and 46 connected to it. All the relays are connected to a current-limited buffer amplifier 48 supplying a low voltage signal, and all the relays 46 are connected to a current-limited buffer amplifier 50 supplying a high voltage signal.

The test programme is arranged so that when any relay 18 is closed the associated relays 44 and 46 for that nail 14 cannot be closed. However, for the remaining seven nails 14 in the same group, either one of the relays 44 and 46 can be closed, irrespective of the setting of the relays for the other nails in the group. The precise combination of relay settings is determined by relay control logic 52 in accordance with the requirements of the test programme.

Thus, for example, while one of the nails 14, say #3, is applying a set of test signals to a component in the UUT 16, or sensing the responses of the component to such a set of signals from a nail 14 in another group, two other nails, say #2 and #7, may be applying static low voltage guard signals to the UUT 16; and three other nails, say #1, #5 and #6, might be applying static high voltage guard signals.

With this arrangement, much flexibility can be achieved in the assignment of nails to specific functions in each step of a test programme; also, the nails which are not currently involved in applying test signals or sensing output signals in a given step can still be put to use, instead of being temporarily redundant. Thus, for example, if an unforeseen need for an additional guard signal at a particular node arises during the test programme development, it may well be found that this node already has a nail assigned to it for input or output in a test step elsewhere in the programme. Accordingly, this existing nail can be used to apply the required new guard signal, simply by arranging for the appropriate relay 44 or 46 to be closed for the relevant steps in the test programme. This avoids the need to modify the test fixture 12, or even completely re-arrange the nail assignments.

## Claims

1. An in-circuit automatic test equipment for testing a digital integrated circuit, the integrated circuit being a component part of a unit (16) under test and having a plurailty of nails (14) for contacting circuit nodes in the unit under test, the nails being arranged in groups;
a plurality of circuits (20), one circuit associated with each group, each for applying a test signal to the unit or sensing a signal in the unit
means (18) for selecting any one nail within each group to selectively connect each circuit to a node of the unit under test via a so selected nail;
means (24, 26) for controlling the circuits to apply and sense a pattern of the test signals sufficient to test the integrated circuit to the unit under test via the selected nails; characterised in that the equipment includes means (44) for selective applying a guard signal to the unit via any one or more of the nails, other than the selected nails.

2. An in-circuit automatic test equipment as claimed in claim 1 and characterised in that a guard signal may be applied via nails within a group where no nail is selected.

3. An in-circuit automatic test equipment as claimed in any preceding claim and characterised in that a relay means (44, 18) is connected to a nail such that in a first relay state the nail may be selected and in a second relay state a guard signal may be applied.

4. An in-circuit automatic test equipment as claimed in claim 3 and characterised in that further relay means (46) is connected to the nail such that alternative guard signals may be applied.

## Patentansprüche

1. Automatische Prüfeinrichtung für das Prüfen eines verschalteten digitalen integrierten Schaltkreises, der eine Komponente einer zu prüfenden Schaltung (16) ist, mit einer Mehrzahl von Stiften (14) für das Kontaktieren von Schaltungsknoten in dem Prüfling, wobei die Stifte in Gruppen angeordnet sind,
mit einer Mehrzahl von Shaltkreisen (20), wobei jeweils ein Schaltkreis jeder Gruppe zugeordnet ist, jeder für das Anlegen eines Prüfsignals an den Prüflung oder für das Erfassen eines Signals im Prüfling.
mit Mitteln (18) für das Auswählen irgendeines Stiftes innerhalb jeder Gruppe zum selektiven Verbinden jedes Schaltkreises mit einem Knoten des Prüflings über den so ausgewählten Stift, und
mit Mitteln (24, 26) für die Steuerung der Schaltkreise zum Anlegen und Erfassen eines Musters von Prüfsignalen derart, daß der integrierte Schaltkreis bezüglich des Prüflings über die ausgewählten Stifte geprüft wird,
dadurch gekennzeichnet, daß die Einrichtung Mittel (44) umfaßt für selektives Anlegen einer Ausblendsignals an den Prüfling über einen oder mehrere der Stifte, welcher bzw. welche nicht zu den ausgewählten Stiften gehört/gehören.

2. Automatische Prüfeinrichtung nach Anspruch 1, dadurch gekennzeichnet, daß das Ausblendsignal über Stifte anlegbar ist innerhalb einer Gruppe, in der kein Stift ausgewählt wurde.

3. Automatische Prüfeinrichtung nach einem der vorangehenden Ansprüche, dadurch gekennzeichnet, daß ein Relaismittel (44, 18) an einen Stift derart angeschlossen ist, daß in einer ersten Relaislage der Stift ausgewählt werden kann und in einer zweiten Relaislage ein Ausblendsignal anlegbar ist.

4. Automatische Prüfeinrichtung nach Anspruch 3, dadurch gekennzeichnet, daß weitere Relaismittel (46) an den Stift derart angeschlossen sind, daß alternative Ausblendsignale anlegbar sind.

**Revendications**

1. Equipement de test automatique in-situ pour tester un circuit intégré numérique, le circuit intégré faisant partie d'une unité (16) en cours de test et ayant une pluralité de broches (14) pour contacter des noeuds du circuit dans l'unité en cours de test, les broches étant disposées par groupes;

une pluralité de circuits (20), un circuit étant associé à chacun des groupes, pour appliquer un signal de test à l'unité ou détecter in signal dans l'unité;

des moyens (18) pour selectionner n'importe quelle broche de chaque groupe connecter sélectivement chaque circuit à un noeud de l'unité en cours de test par l'intermédiaire d'une broche ainsi sélectionnée;

des moyens (24, 26) pour commander les circuits pour appliquer et détecter une configuration de signaux de test suffisante pour tester le circuit intégré à l'unité en cours de test par l'intermédiaire des broches sélectionnées;

caractérisé en ce que l'équipement comprend des moyens (44) pour appliquer sélectivement un signal de garde à l'unité par au moins une quelconque des broches autres que les broches sélectionnées.

2. Equipement de test automatique in-situ selon la revendication 1, caractérisé en ce qu'un signal de garde peut être appliqué par l'intermédiaire de broches d'un groupe où aucune broche n'est sélectionnée.

3. Equipement de test automatique in-site selon l'une des revendications précédentes, caractérisé en ce que des moyens relais (44, 18) sont connectés à une broche de façon que, dans un premier état du relais, la broche puisse être sélectionée et que, dans un deuxième état du relais, un signal de garde puisse être appliqué.

4. Equipement de test automatique in-situ selon la revendication 3, caractérisé en ce que d'autres moyens relais (46) sont connectés à la broche de façon que d'autres signaux de garde puissent être appliqués.

FIG.1

FIG.2

0 145 194